# EUROPÄISCHE PATENTSCHRIFT

(11) **EP 1 507 893 B1**
(45) Veröffentlichungstag und Bekanntmachung des Hinweises auf die Patenterteilung: **26.03.2014**
(21) Anmeldenummer: 03724885.3
(22) Anmeldetag: 09.05.2003
(51) Int. Cl.: C23C 16/54, C23C 16/04

(54) **VERFAHREN UND VORRICHTUNG ZUR PLASMABEHANDLUNG VON WERKSTÜCKEN**
METHOD AND DEVICE FOR THE PLASMA TREATMENT OF WORKPIECES
PROCEDE ET DISPOSITIF POUR LE TRAITEMENT AU PLASMA DE PIECES

(30) Priorität: 24.05.2002 DE 10223288; 11.06.2002 DE 10225985
(43) Veröffentlichungstag der Anmeldung: 23.02.2005
(73) Patentinhaber: KHS Corpoplast GmbH, 22145 Hamburg (DE)
(72) Erfinder: LITZENBERG, Michael, 21502 Geesthacht (DE); LEWIN, Frank, 22889 Tangstedt (DE); MÜLLER, Hartwig, 22952 Lütjensee (DE); VOGEL, Klaus, 22885 Barsbüttel (DE); ARNOLD, Gregor, 55294 Bodenheim (DE); BEHLE, Stephan, 55239 Gau-Odernheim (DE); LÜTTRINGHAUS-HENKEL, Andreas, 64289 Darmstadt (DE); BICKER, Matthias, 55126 Mainz (DE); KLEIN, Jürgen, 55127 Mainz (DE)
(74) Vertreter: Meissner, Bolte & Partner
(86) Internationale Anmeldenummer: PCT/DE2003/001506
(87) Internationale Veröffentlichungsnummer: WO 2003/100127

(56) Entgegenhaltungen:
- WO-A-00/58631
- WO-A-95/22413
- WO-A-99/17334
- DE-A- 19 916 478
- GB-A- 547 249
- US-A- 2 730 987
- PATENT ABSTRACTS OF JAPAN vol. 009, no. 222 (C-302), 9. September 1985 (1985-09-09) & JP 60 082670 A (SUWA SEIKOSHA KK), 10. Mai 1985 (1985-05-10)

## Beschreibung

Die Erfindung betrifft ein Verfahren zur Plasmabehandlung von Werkstücken, bei dem ein als Behälter ausgebildetes Werkstück mit einer Innenbeschichtung als Barriereschicht versehen wird, wobei zur Erzeugung der Barriereschicht ein Prozeßgas verwendet wird und bei dem das Werkstück in eine zumindest teilweise evakuierbare Kammer einer Behandlungsstation eingesetzt wird und bei dem das Werkstück innerhalb der Behand-lungsstation von einem Halteelement positioniert wird und bei dem mindestens ein Betriebsmittel mindestens teilweise von einer Fördereinrichtung beaufschlagt wird.

Die Erfindung betrifft darüber hinaus eine Vorrichtung zur Plasmabehandlung von Werkstücken, bei dem ein als Behälter ausgebildetes Werkstück mit einer Innenbeschichtung als Barriereschicht versehen wird, wobei zur Erzeugung der Barriereschicht ein Prozeßgas verwendet wird und die mindestens eine evakuierbare Plasmakammer zur Aufnahme der Werkstücke aufweist und bei der die Plasmakammer im Bereich einer Behandlungsstation angeordnet ist, sowie bei der die Plasmakammer von einem Kammerboden, einem Kammerdeckel sowie einer seitlichen Kammerwandung begrenzt ist und mindestens ein Halteelement zur Positionierung des Werkstückes aufweist und bei der die Plasmakammer auf einer umlaufenden Trageeinrichtung angeordnet ist

Derartige Verfahren und Vorrichtungen werden beispielsweise eingesetzt, um Kunststoffe mit Oberflächenbeschichtungen zu versehen. Insbesondere sind auch bereits derartige verfahren und Vorrichtungen bekannt, um innere oder äußere Oberflächen von Behältern zu beschichten, die zur Verpackung von Flüssigkeiten vorgesehen sind. Darüber hinaus sind Einrichtungen zur Plasmasterilisation bekannt.

In der PCT-WO 95/22413 wird eine Plasmakammer zur Innenbeschichtung von Flaschen aus PET beschrieben. Die zu beschichtenden Flaschen werden durch einen beweglichen Boden in eine Plasmakammer hineingehoben und im Bereich einer Flaschenmündung mit einem Adapter in Verbindung gebracht. Durch den Adapter hindurch kann eine Evakuierung des Flascheninnenraumes erfolgen. Darüber hinaus wird durch den Adapter hindurch eine hohle Lanze in den Innenraum der Flaschen eingeführt, um Prozeßgas zuzuführen. Eine zündung des Plasmas erfolgt unter Verwendung einer Mikrowelle.

Aus dieser Veröffentlichung ist es auch bereits bekannt, eine Mehrzahl von Plasmakammern auf einem rotierenden Rad anzuordnen. Hierdurch wird eine hohe Produktionsrate von Flaschen je Zeiteinheit unterstützt. Auf dem rotierenden Rad sind Ventile für die steuerbare Verbindung mit einer Vakuumversorgung angeordnet.

In der EP-OS 10 10 773 wird eine Zuführeinrichtung erläutert, um einen Flascheninnenraum zu evakuieren und mit Prozeßgas zu versorgen. In der PCT-WO 01/31680 wird eine Plasmakammer beschrieben, in die die Flaschen von einem beweglichen Deckel eingeführt werden, der zuvor mit einem Mündungsbereich der Flaschen verbunden wurde.

Die PCT-WO 00/58631 zeigt ebenfalls bereits die Anordnung von Plasmastationen auf einem rotierenden Rad und beschreibt für eine derartige Anordnung eine gruppenweise Zuordnung von Unterdruckpumpen und Plasmastationen, um eine günstige Evakuierung der Kammern sowie der Innenräume der Flaschen zu unterstützen. Darüber hinaus wird die Beschichtung von mehreren Behältern in einer gemeinsamen Plasmastation bzw. einer gemeinsamen Kavität erwähnt.

Eine weitere Anordnung zur Durchführung einer Innenbeschichtung von Flaschen wird in der PCT-WO 99/17334 beschrieben. Es wird hier insbesondere eine Anordnung eines Mikrowellengenerators oberhalb der Plasmakammer sowie eine Vakuum- und Betriebsmittelzuleitung durch einen Boden der Plasmakammer hindurch beschrieben.

Aus der DE 199 16 478 A ist es bekannt, eine Plasmasterilisation von Behältern durchzuführen. Entlang eines kreisförmigen Transportweges der Behälter sind Unterdruckpumpen angeordnet, die zur stufenweisen Generierung eines Vakuums verwendet werden.

In der GB 547249 A werden ebenfalls eine Mehrzahl von Unterdruckpumpen beschrieben, die stationär um einen radartigen Drehkörper herum angeordnet sind.

Bei der überwiegenden Anzahl der bekannten Verfahren werden zur Verbesserung von Barriereeigenschaften des thermoplastischen Kunststoffmaterials durch das Plasma erzeugte Behälterschichten aus Siliziumoxiden mit der allgemeinen chemischen Formel SiOx verwendet. Zusätzlich können in den hierdurch erzeugten Barriereschichten auch Anteile von Kohlenstoff, Wasserstoff und Stickstoff enthalten sein. Derartige Barriereschichten verhindern ein Eindringen von Sauerstoff in die verpackten Flüssigkeiten sowie ein Austreten von Kohlendioxid bei CO₂-haltigen Flüssigkeiten.

Die bislang bekannten Verfahren und Vorrichtungen sind noch nicht in ausreichender Weise dafür geeignet, für eine Massenproduktion eingesetzt zu werden, bei der sowohl ein geringer Beschichtungspreis je Werkstück als auch eine hohe Produktionsgeschwindigkeit erreicht werden muß.

Aufgabe der vorliegenden Erfindung ist es daher, ein Verfahren der einleitend genannten Art derart anzugeben, daß eine Betriebsmittelzuführung zur Behandlungsstation bei kompaktem Aufbau, kurzer Prozeßnebenzeiten und großer Zuverlässigkeit unterstützt wird.

Diese Aufgabe wird erfindungsgemäß dadurch gelöst, daß die Fördereinrichtung gemeinsam mit der Behandlungsstation auf einem geschlossenen und umlaufenden Transportweg bewegt wird, wobei von der Fördereinrichtung ein Unterdruck erzeugt wird und wobei die Fördereinrichtung auf einem niedrigeren Höhenniveau als die Kammern positioniert wird.

Weitere Aufgabe der vorliegenden Erfindung ist es, eine Vorrichtung der einleitend genannten Art derart zu konstruieren, daß eine Betriebsmittelzuführung zur Plasmakammer bei kompaktem Aufbau unterstützt wird.

Diese Aufgabe wird erfindungsgemäß dadurch gelöst, daß mindestens eine Fördereinrichtung für ein Betriebsmittel auf der umlaufenden Trageinrichtung angeordnet ist, daß die Fördereinrichtung zur Erzeugung eines Unterdruckes ausgebildet ist und daß die Fördereinrichtung auf einem niedrigeren Höhenniveau als die Plasmakammern angeordnet ist.

Durch die gemeinsame Anordnung der Plasmakammer sowie der Fördereinrichtung für das Betriebsmittel auf einer umlaufenden Trageinrichtung ist es möglich, das Betriebsmittel in der erforderlichen Form in unmittelbarer Nähe zur Plasmakammer bereitzustellen. Es wird hierdurch ein kompakter Aufbau unterstützt, darüber hinaus können sehr kurze Verbindungsleitungen verwendet werden. Strömungsverluste entlang langer Leitungen werden darüber hinaus durch die relativ zueinander räumlich dichte Anordnung der Fördereinrichtung und der Plasmakammer vermieden, so daß kurze Prozeßnebenzeiten ermöglicht werden.

Eine schnelle Erreichung der für die Plasmabehandlung erforderlichen physikalischen Bedingungen wird dadurch unterstützt, daß von der Fördereinrichtung ein Unterdruck erzeugt wird.

Eine schnelle Evakuierung wird ebenfalls dadurch unterstützt, daß von mindestens zwei Fördereinrichtungen mindestens zwei unterschiedliche Unterdrücke erzeugt werden

Ein guter Kompromiß zwischen einem geringen zu transportierenden Gewicht und einer verzögerungsarmen Betriebsmittelbereitstellung wird dadurch bereitgestellt, daß für mindestens eine Fördereinrichtung von mindestens einer externen Vorstufe ein vorkonditioniertes Betriebsmittel bereitgestellt wird.

Eine Verbindung von stationären und bewegten Komponenten kann dadurch erfolgen, daß das Betriebsmittel über eine Drehkupplung in den Bereich der Fördereinrichtung geleitet wird.

Eine vorteilhafte Schwerpunktpositionierung wird dadurch erreicht, daß die Fördereinrichtung das Betriebsmittel von einem Höhenniveau der Fördereinrichtung auf ein höheres Niveau der Plasmastation transportiert.

Für einen Anschluß einer Mehrzahl von Plasmastationen wird vorgeschlagen, daß mindestens zwei Plasmastationen über einen Verteiler mit mindestens einer gemeinsamen Fördereinrichtung verbunden werden.

Eine Betriebsmittelzuführung mit kurzen Verbindungsleitungen kann dadurch erreicht werden, daß mindestens ein Betriebsmittel von mindestens einem Verteiler auf einem Höhenniveau eines Kammersockels der Plasmastation verteilt wird.

Insbesondere ist auch daran gedacht, daß eine Zuführung des Betriebsmittels vom Verteiler in Richtung auf die Plasmastationen über gerade und ausgehend vom Verteiler radial nach außen verlaufende Anschlußleitungen durchgeführt wird.

Eine kompakte Verteilung unterschiedlicher Betriebsmittel wird dadurch unterstützt, daß mindestens zwei Betriebsmittel auf unterschiedlichen Verteilebenen zu den Plasmastationen geleitet werden.

Bei einer Verwendung von rotierenden Trageinrichtungen erweist es sich als besonders vorteilhaft, daß die Fördereinrichtungen im Bereich der Trageinrichtung derart angeordnet werden, daß eine im wesentlichen ausgewuchtete Gewichtsverteilung bereitgestellt wird.

Eine Kombination einer günstigen Gewichtsverteilung sowie einer guten zugänglichkeit kann dadurch bereitgestellt werden, daß entlang eines Umfanges der Trageinrichtung abwechselnd Fördereinrichtungen sowie Verteilschränke für elektrische Anschlüsse positioniert werden.

Eine mechanisch sehr stabile Anordnung, die zugleich eine exakt reproduzierbare Durchführung sämtlicher Prozeßschritte unterstützt, kann dadurch erreicht werden, daß die Fördereinrichtung gemeinsam mit der Plasmastation auf einem rotierenden Plasmarad als Trageinrichtung positioniert wird.

Eine typische Anwendung besteht darin, daß ein Werkstück aus einem thermoplastischen Kunststoff behandelt wird.

Insbesondere ist daran gedacht daß ein Innenraum des Werkstückes behandelt wird.

Ein umfangreiches Anwendungsgebiet wird dadurch erschlossen, daß als Werkstück ein Behälter behandelt wird.

Insbesondere ist dabei daran gedacht, daß als Werkstück eine Getränkeflasche behandelt wird.

Eine hohe Produktionsrate bei großer Zuverlässigkeit und hoher Produktqualität kann dadurch erreicht werden, daß die mindestens eine Plasmastation von einem rotierenden Plasmarad von einer Eingabepositionierung in eine Ausgabepositionierung überführt wird.

Eine Vergrößerung der Produktionskapazität bei nur geringfügig gesteigertem gerätetechnischen Aufwand kann dadurch erreicht werden, daß von einer Plasmastation mehrere Kavitäten bereitgestellt werden.

Eine mechanisch hoch belastbare Ausführungsform wird dadurch bereitgestellt, daß die Fördereinrichtungen von einem radringartigen Plasmarad transportiert werden.

Eine typische Anwendung wird dadurch definiert, daß als Plasmabehandlung eine Plasmabeschichtung durchgeführt wird.

Insbesondere ist daran gedacht, daß die Plasmabehandlung unter Verwendung eines Niederdruckplasmas durchgeführt wird.

Bei einer Beschichtung von Werkstücken aus Kunststoff erweist es sich als vorteilhaft, daß eine Plasmapolymerisation durchgeführt wird.

Eine gute Oberflächenhaftung wird dadurch unterstützt, daß durch das Plasma mindestens zum Teil organische Substanzen abgeschieden werden.

Besonders vorteilhafte Verwendungseigenschaften bei Werkstücken zur Verpackung von Lebensmitteln können dadurch erreicht werden, daß durch das Plasma mindestens zum Teil anorganische Substanzen abgeschieden werden.

Bei der Behandlung von Verpackungen ist insbesondere daran gedacht, daß durch das Plasma eine Substanz zur Verbesserung von Barriereeigenschaften des Werkstückes abgeschieden wird.

Zur Unterstützung einer hohen Gebrauchsqualität wird vorgeschlagen, daß zusätzlich ein Haftvermittler zur Verbesserung eines Anhaftens der Substanz auf einer Oberfläche des Werkstückes abgeschieden wird.

Eine hohe Produktivität kann dadurch unterstützt werden, daß in einer gemeinsamen Kavität mindestens zwei Werkstücke gleichzeitig behandelt werden.

Ein weiteres Anwendungsgebiet besteht darin, daß als Plasmabehandlung eine Plasmasterilisation durchgeführt wird.

Ebenfalls ist daran gedacht, daß als Plasmabehandlung eine Oberflächenaktivierung des Werkstückes durchgeführt wird. Eine kompakte und hochbelastbare Konstruktion kann dadurch erreicht werden, daß das Plasmarad mit einem Tragring versehen ist, der ein im wesentlichen c-förmiges Vertikalprofil aufweist.

Eine besonders niedrige Schwerpunktanordnung wird dadurch erreicht, daß die Fördereinrichtung auf einem Basisschenkel des Tragringes angeordnet ist.

Eine modulare Grundkonstruktion mit guter Zugänglichkeit der einzelnen Funktionskomponenten wird dadurch bereitgestellt, daß die Plasmastationen auf einem Abschlußschenkel des Tragringes angeordnet sind.

In den Zeichnungen sind Ausführungsbeispiele der Erfindung schematisch dargestellt. Es zeigen:
- Fig.: 1 Eine Prinzipskizze einer Mehrzahl von Plasmakammern, die auf einem rotierenden Plasmarad angeordnet sind und bei der das Plasmarad mit Eingabeund Ausgaberädern gekoppelt ist.
- Fig. 2: eine Anordnung ähnlich zu Fig. 1, bei der die Plasmastation jeweils mit zwei Plasmakammern ausgestattet sind,
- Fig. 3: eine perspektivische Darstellung eines Plasmarades mit einer Vielzahl von Plasmakammern,
- Fig. 4: eine perspektivische Darstellung einer Plasmastation mit einer Kavität,
- Fig. 5: eine Vorderansicht der Vorrichtung gemäß Fig. 4 mit geschlossener Plasmakammer,
- Fig. 6: einen Querschnitt gemäß Schnittlinie VI-VI in Fig. 5,
- Fig. 7: eine Darstellung entsprechend Fig. 5 mit geöffneter Plasmakammer,
- Fig. 8: einen Vertikalschnitt gemäß Schnittlinie VIII-VIII in Fig. 7,
- Fig. 9: eine vergrößerte Darstellung der Plasmakammer mit zu beschichtender Flasche gemäß Fig. 6,
- Fig. 10: eine perspektivische Darstellung einer Trageinrichtung, die auf einem rotierenden Plasmarad angeordnete Betriebsmittelpumpen sowie ebenfalls auf dem Plasmarad angeordnete Plasmastationen mit jeweils zwei Plasmakammern aufweist,
- Fig. 11: eine weitere Darstellung eines Plasmarades ähnlich zu Fig. 10 ohne dargestellte Verteilerkästen sowie in einer teilweise transparenten Darstellung,
- Fig. 12: das Plasmarad gemäß Fig. 11 in einem teilmontierten Zustand,
- Fig. 13: das Plasmarad gemäß Fig. 11 mit lediglich einer montierten Plasmastation,
- Fig. 14: das Plasmarad gemäß Fig. 13 in einer anderen perspektivischen Darstellung und mit abgebildeten externen Fördereinrichtungen für Betriebsmittel,
- Fig. 15: eine schematische Darstellung eines anderen Plasmarades, bei dem Fördereinrichtungen für Betriebsmittel in einem in lotrechter Richtung oberen Bereich angeordnet sind und
- Fig. 16: eine teilweise Darstellung einer weiteren Konstruktion eines Plasmarades, das hängend gelagert ist und bei dem Fördereinrichtungen für Betriebsmittel in lotrechter Richtung oberhalb der Plasmastationen positioniert sind.

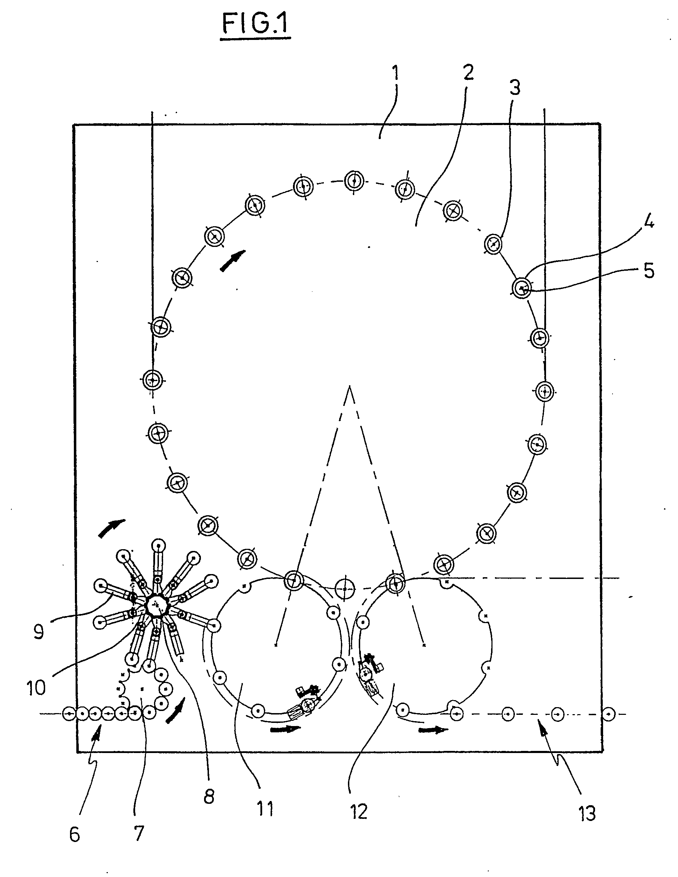

Aus der Darstellung in Fig. 1 ist ein Plasmamodul (1) zu erkennen, das mit einem rotierenden Plasmarad (2) versehen ist. Entlang eines Umfanges des Plasmarades (2) sind eine Mehrzahl von Plasmastationen (3) angeordnet. Die Plasmastationen (3) sind mit Kavitäten (4) bzw. Plasmakammern (17) zur Aufnahme von zu behandelnden Werkstücken (5) versehen.

Die zu behandelnden Werkstücke (5) werden dem Plasmamodul (1) im Bereich einer Eingabe (6) zugeführt und über ein Vereinzelungsrad (7) an ein Übergaberad (8) weitergeleitet, das mit positionierbaren Tragarmen (9) ausgestattet ist. Die Tragarme (9) sind relativ zu einem Sockel (10) des Übergaberades (8) verschwenkbar angeordnet, so daß eine Abstandsveränderung der Werkstücke (5) relativ zueinander durchgeführt werden kann. Hierdurch erfolgt eine Übergabe der Werkstücke (5) vom Übergaberad (8) an ein Eingaberad (11) mit einem relativ zum Vereinzelungsrad (7) vergrößerten Abstand der Werkstücke (5) relativ zueinander. Das Eingaberad (11) übergibt die zu behandelnden Werkstücke (5) an das Plasmarad (2). Nach einer Durchführung der Behandlung werden die behandelten Werkstücke (5) von einem Ausgaberad (12) aus dem Bereich des Plasmarades (2) entfernt und in den Bereich einer Ausgabestrecke (13) überführt.

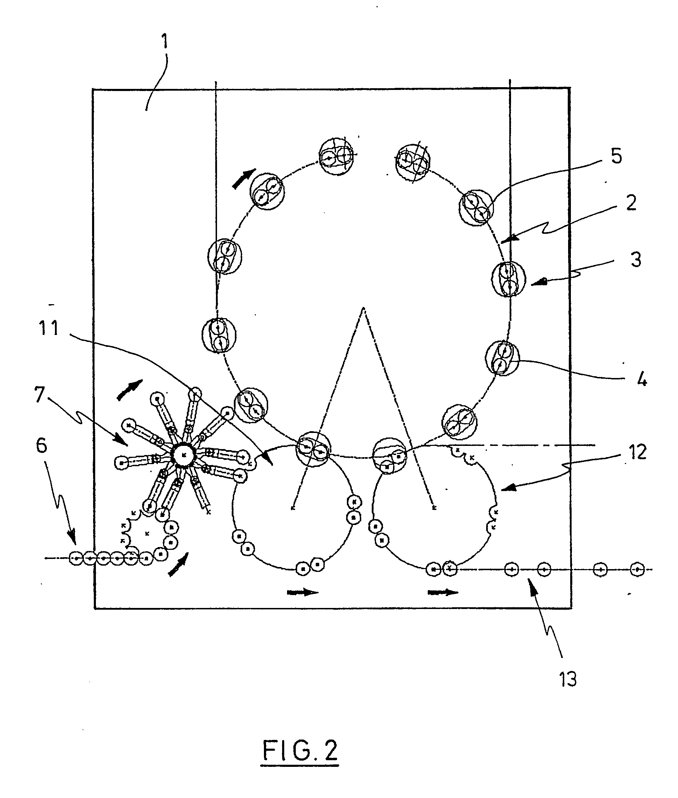

Bei der Ausführungsform gemäß Fig. 2 sind die Plasmastationen (3) jeweils mit zwei Kavitäten (4) bzw. Plasmakammern (17) ausgestattet. Hierdurch können jeweils zwei Werkstücke (5) gleichzeitig behandelt werden. Grundsätzlich ist es hierbei möglich, die Kavitäten (4) vollständig voneinander getrennt auszubilden, grundsätzlich ist es aber auch möglich, in einem gemeinsamen Kavitätenraum lediglich Teilbereiche derart gegeneinander abzugrenzen, daß eine optimale Beschichtung aller Werkstücke (5) gewährleistet ist. Insbesondere ist hierbei daran gedacht, die Teilkavitäten zumindest durch separate Mikrowelleneinkopplungen gegeneinander abzugrenzen.

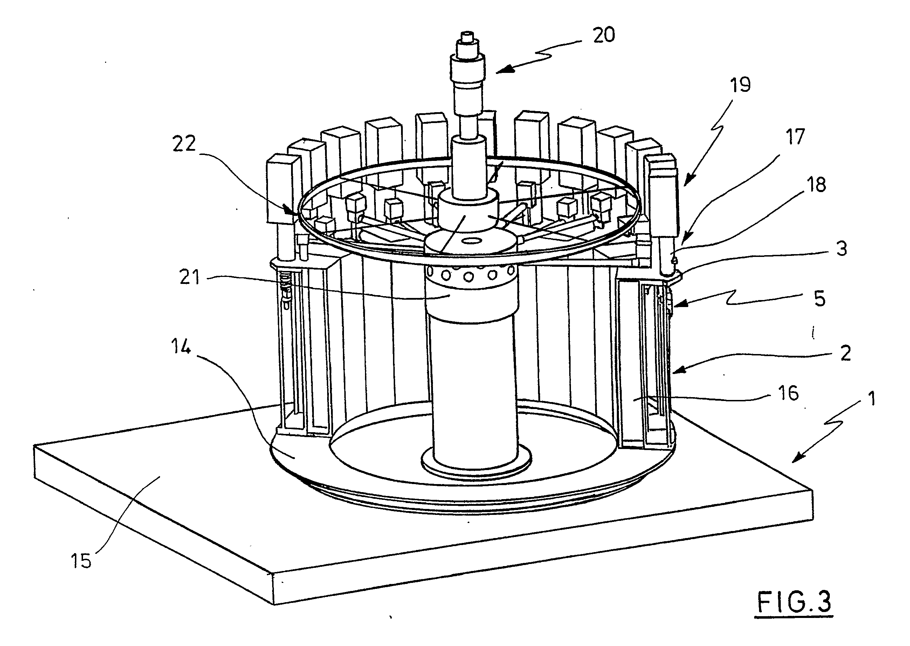

Fig. 3 zeigt eine perspektivische Darstellung eines Plasmamoduls (1) mit teilweise aufgebautem Plasmarad (2). Die Plasmastationen (3) sind auf einem Tragring (14) angeordnet, der als Teil einer Drehverbindung ausgebildet und im Bereich eines Maschinensockels (15) gelagert ist. Die Plasmastationen (3) weisen jeweils einen Stationsrahmen (16) auf, der Plasmakammern (17) haltert. Die Plasmakammern (17) weisen zylinderförmige Kammerwandungen (18) sowie Mikrowellengeneratoren (19) auf.

In einem Zentrum des Plasmarades (2) ist ein Drehverteiler (20) angeordnet, über den die Plasmastationen (3) mit Betriebsmitteln sowie Energie versorgt werden. Zur Betriebsmittelverteilung können insbesondere Ringleitungen (21) eingesetzt werden.

Die zu behandelnden Werkstücke (5) sind unterhalb der zylinderförmigen Kammerwandungen (18) dargestellt. Unterteile der Plasmakammern (17) sind zur Vereinfachung jeweils nicht eingezeichnet.

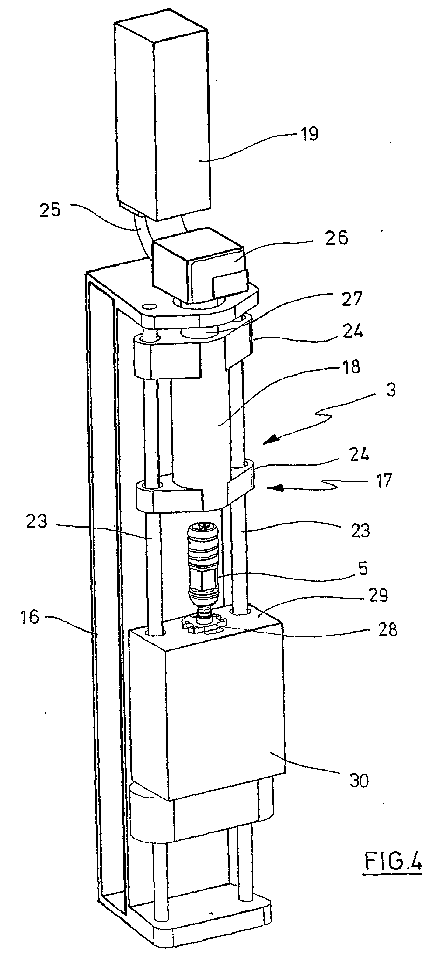

Fig. 4 zeigt eine Plasmastation (3) in perspektivischer Darstellung. Es ist zu erkennen, daß der Stationsrahmen (16) mit Führungsstangen (23) versehen ist, auf denen ein Schlitten (24) zur Halterung der zylinderförmigen Kammerwandung (18) geführt ist. Fig. 4 zeigt den Schlitten (24) mit Kammerwandung (18) in einem angehobenen Zustand, so daß das Werkstück (5) freigegeben ist.

Im oberen Bereich der Plasmastation (3) ist der Mikrowellengenerator (19) angeordnet. Der Mikrowellengenerator (19) ist über eine Umlenkung (25) und einen Adapter (26) an einen Kopplungskanal (27) angeschlossen, der in die Plasmakammer (17) einmündet. Grundsätzlich kann der Mikrowellengenerator (19) sowohl unmittelbar im Bereich des Kammerdekkels (31) als auch über ein Distanzelement an den Kammerdeckel (31) angekoppelt mit einer vorgebbaren Entfernung zum Kammerdeckel (31) und somit in einem größeren Umgebungsbereich des Kammerdeckels (31) angeordnet werden. Der Adapter (26) hat die Funktion eines Übergangselementes und der Kopplungskanal (27) ist als ein Koaxialleiter ausgebildet. Im Bereich einer Einmündung des Kopplungskanals (27) in den Kammerdeckel (31) ist ein Quarzglasfenster angeordnet. Die Umlenkung (25) ist als ein Hohlleiter ausgebildet.

Das Werkstück (5) wird im Bereich eines Dichtelementes (28) positioniert, das im Bereich eines Kammerbodens (29) angeordnet ist. Der Kammerboden (29) ist als Teil eines Kammersockels (30) ausgebildet. Zur Erleichterung einer Justage ist es möglich, den Kammersockel (30) im Bereich der Führungsstangen (23) zu fixieren. Eine andere Variante besteht darin, den Kammersockel (30) direkt am Stationsrahmen (16) zu befestigen. Bei einer derartigen Anordnung ist es beispielsweise auch möglich, die Führungsstangen (23) in vertikaler Richtung zweiteilig auszuführen.

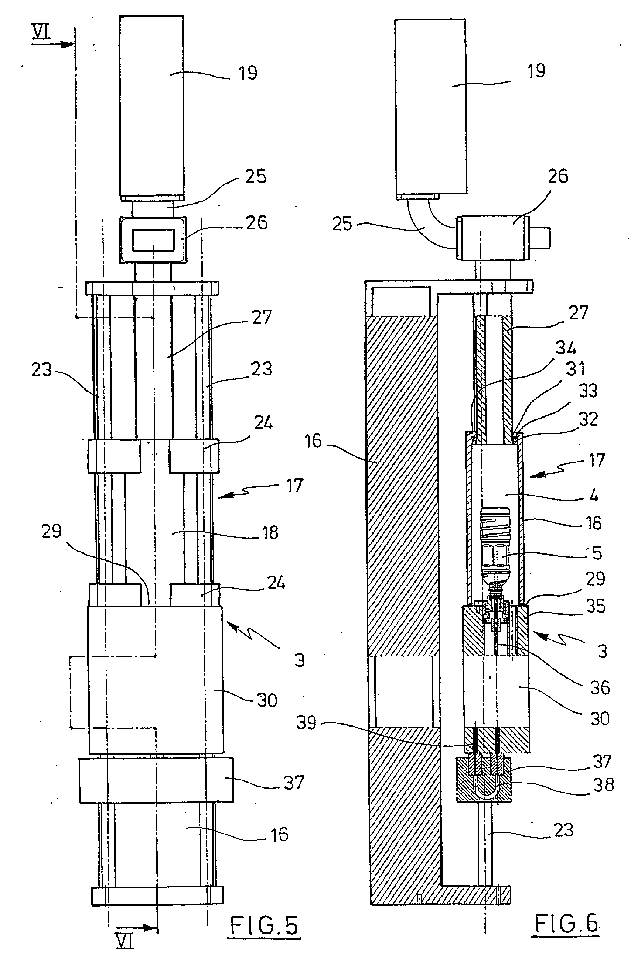

Fig. 5 zeigt eine Vorderansicht der Plasmastation (3) gemäß
Fig. 3 in einem geschlossenen Zustand der Plasmakammer (17). Der Schlitten (24) mit der zylinderförmigen Kammerwandung (18) ist hierbei gegenüber der Positionierung in
Fig. 4 abgesenkt, so daß die Kammerwandung (18) gegen den Kammerboden (29) gefahren ist. In diesem Positionierzustand kann die Plasmabeschichtung durchgeführt werden.
Fig. 6 zeigt in einer Vertikalschnittdarstellung die Anordnung gemäß Fig. 5. Es ist insbesondere zu erkennen, daß der Kopplungskanal (27) in einen Kammerdeckel (31) einmündet, der einen seitlich überstehenden Flansch (32) aufweist. Im Bereich des Flansches (32) ist eine Dichtung (33) angeordnet, die von einem Innenflansch (34) der Kammerwandung (18) beaufschlagt wird. In einem abgesenkten Zustand der Kammerwandung (18) erfolgt hierdurch eine Abdichtung der Kammerwandung (18) relativ zum Kammerdeckel (31). Eine weitere Dichtung (35) ist in einem unteren Bereich der Kammerwandung (18) angeordnet, um auch hier eine Abdichtung relativ zum Kammerboden (29) zu gewährleisten.

In der in Fig. 6 dargestellten Positionierung umschließt die Kammerwandung (18) die Kavität (4), so daß sowohl ein Innenraum der Kavität (4) als auch ein Innenraum des Werkstückes (5) evakuiert werden können. Zur Unterstützung einer Zuleitung von Prozeßgas ist im Bereich des Kammersokkels (30) eine hohle Lanze (36) angeordnet, die in den Innenraum des Werkstückes (5) hineinverfahrbar ist. Zur Durchführung einer Positionierung der Lanze (36) wird diese von einem Lanzenschlitten (37) gehaltert, der entlang der Führungsstangen (23) positionierbar ist. Innerhalb des Lanzenschlittens (37) verläuft ein Prozeßgaskanal (38), der in der in Fig. 6 dargestellten angehobenen Positionierung mit einem Gasanschluß (39) des Kammersockels (30) gekoppelt ist. Durch diese Anordnung werden schlauchartige Verbindungselemente am Lanzenschlitten (37) vermieden.

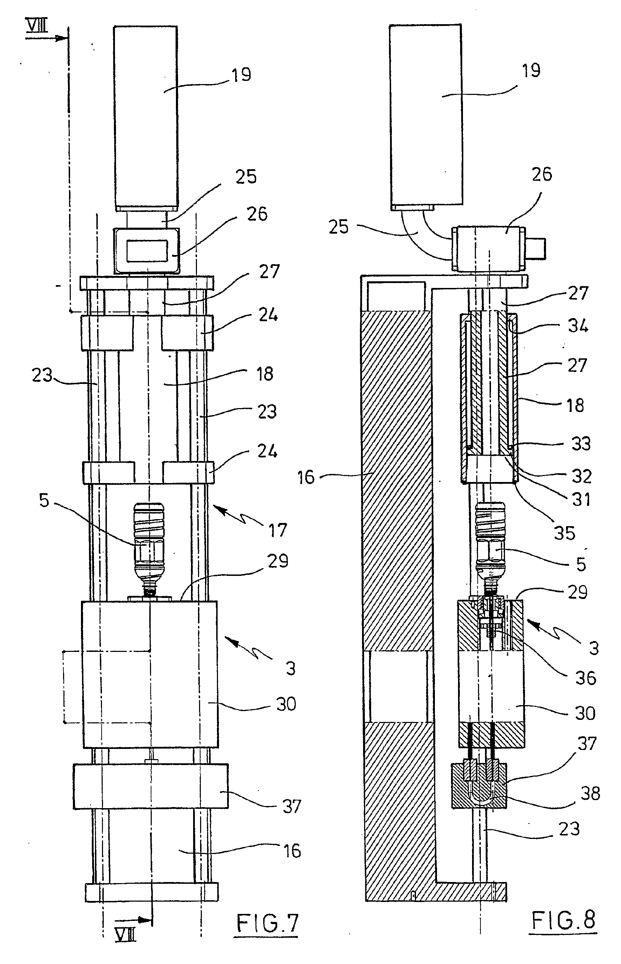

Fig. 7 und Fig. 8 zeigen die Anordnung gemäß Fig. 5 und Fig. 6 in einem angehobenen Zustand der Kammerwandung (18). In diesem Positionierungszustand der Kammerwandung (18) ist es problemlos möglich, das behandelte Werkstück (5) aus dem Bereich der Plasmastation (3) zu entfernen und ein neues zu behandelndes Werkstück (5) einzusetzen. Alternativ zu der in den Zeichnungen dargestellten Positionierung der Kammerwandung (18) in einem durch Verschiebung nach oben erreichten geöffneten Zustand der Plasmakammer (17) ist es auch möglich, den Öffnungsvorgang durch eine Verschiebung einer konstruktiv modifizierten hülsenförmigen Kammerwandung in vertikaler Richtung nach unten durchzuführen.

Im dargestellten Ausführungsbeispiel besitzt der Kopplungskanal (27) eine zylinderförmige Gestaltung und ist im wesentlichen koaxial zur Kammerwandung (18) angeordnet.

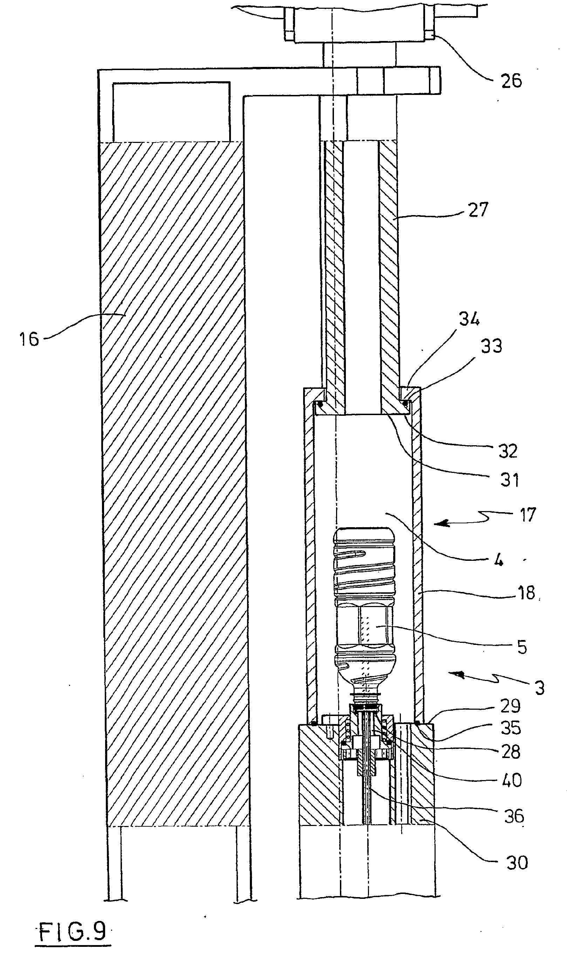

Fig. 9 zeigt den Vertikalschnitt gemäß Fig. 6 in einer vergrößerten teilweisen Darstellung in einer Umgebung der Kammerwandung (18). Zu erkennen ist insbesondere das Übergreifen des Innenflansches (34) der Kammerwandung (18) über den Flansch (32) des Kammerdeckels (31) und die Halterung des Werkstückes (5) durch das Halteelement (28). Darüber hinaus ist zu erkennen, daß die Lanze (36) durch eine Ausnehmung (40) des Halteelementes (28) hindurchgeführt ist.

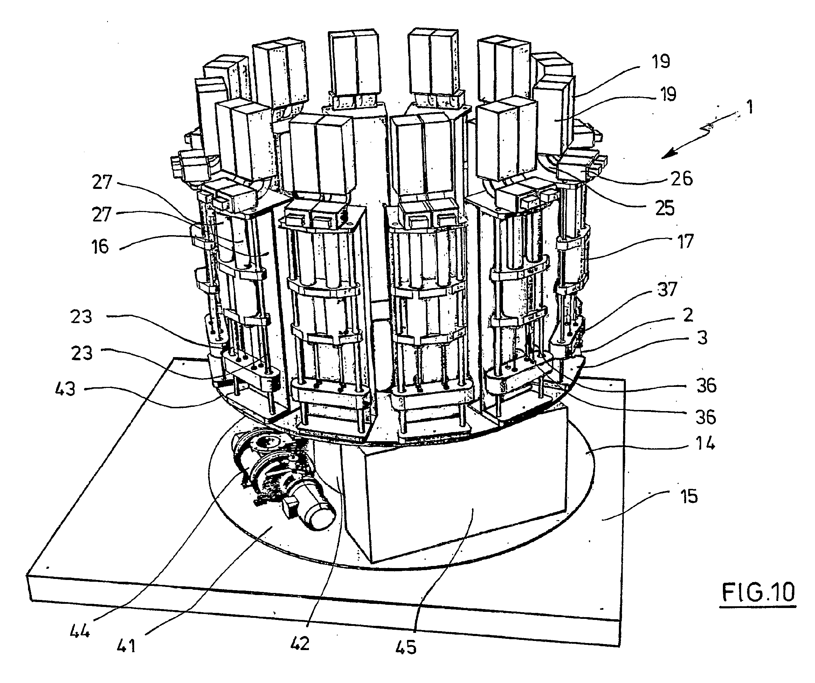

Fig. 10 zeigt ein gegenüber der Darstellung in Fig. 3 abgewandeltes Plasmamodul (1). Das Plasmarad (2) ist hier für einen umlaufenden Transport von Plasmastationen (3) ausgebildet, die mit jeweils zwei Plasmakammern (17) versehen sind. Für jede der Plasmakammern (17) weist jede der Plasmastationen (3) zwei Mikrowellengeneratoren (19), zwei Umlenkungen (25) sowie zwei Adapter (26) auf, die die Mikrowellen zur Zündung des Plasmas über Kopplungskanäle (27) in die zugeordneten Plasmakammern (17) einleiten. Der Tragring (14) des Plasmarades (2) besitzt in einem vertikalen Querschnitt ein c-förmiges Profil mit einem Basisschenkel (41), einem Distanzschenkel (42) sowie einem Abschlußschenkel (43). Der Distanzschenkel (42) verläuft im wesentlichen in einer vertikalen Richtung, der Basisschenkel und der Abschlußschenkel (43) sind im wesentlichen horizontal angeordnet. Der Basisschenkel (41) und der Abschlußschenkel (43) erstrecken sich ausgehend vom Distanzschenkel (42) in eine radial nach außen weisende Richtung.

In lotrechter Richtung oberhalb des Abschlußschenkels (42) sind die Plasmastationen (3) angeordnet. Bei der Ausführungsform gemäß Fig. 10 sind auf dem Basisschenkel (41) Fördereinrichtungen (44) für ein Betriebsmittel angeordnet. Das Betriebsmittel wird den Plasmastationen (3) zugeführt. Im dargestellten Ausführungsbeispiel ist die Fördereinrichtung (44) als eine Vakuumpumpe realisiert. Zusätzlich zu den Fördereinrichtungen (44) sind auch Verteilschränke (45) für eine elektrische Versorgung der Plasmastationen (3) auf dem Basisschenkel (41) angeordnet. Die Anordnung der Fördereinrichtungen (44) und der Verteilschränke (45) erfolgt dabei innerhalb des vom c-förmigen Profil des Tragringes (14) bereitgestellten Aufnahmeraumes.

Bei einer Rotation des Plasmarades (2) rotieren durch die erläuterte Anordnung die Fördereinrichtungen (44) und die Verteilschränke (45) gemeinsam mit den Plasmastationen (3) und es liegt auch keine Relativbewegung zwischen diesen Baugruppen vor. Entsprechende Verbindungsleitungen können somit in einfacher Weise realisiert werden.

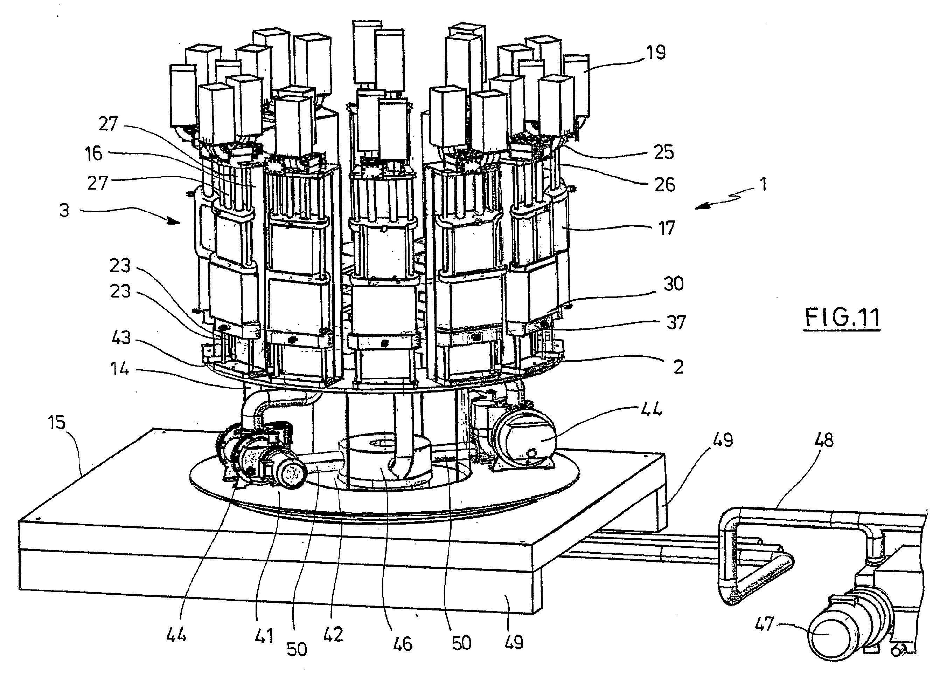

Fig. 11 zeigt ein gegenüber der Darstellung in Fig. 10 leicht modifiziertes Plasmamodul (1) in einer anderen Darstellung und mit teilweise veränderter Abbildung der Einzelteile. Die Mikrowellengeneratoren (19) sind gegenüber der Darstellung in Fig. 10 anders positioniert. Zusätzlich sind in Fig. 11 zwischen dem Lanzenschlitten (37) und den Plasmakammern (17) die Kammersockel (30) eingezeichnet, in deren Bereich insbesondere Steuerventile zur Betriebsmittelversorgung der Plasmastationen (3) angeordnet werden können.

Die Verteilschränke (45) sind nicht in Fig. 11 dargestellt, so daß ein Blick in das Zentrum des Plasmarades (2) möglich ist. Es ist zu erkennen, daß etwa auf einem Höhenniveau der Fördereinrichtungen (44) eine Drehkupplung (46) angeordnet ist. Die Drehkupplung (46) dient zur Verbindung der Fördereinrichtungen (44) mit externen Fördereinrichtungen (47). Bei einem Betrieb der Plasmastationen (3) mit drei unterschiedlichen Unterdrücken, nämlich einem ersten Unterdruck, einem relativ zum ersten Unterdruck niedrigeren zweiten Unterdruck sowie einem Prozeßunterdruck wird die Drehkupplung (46) als Drei-Wege-Vakuum-Dreheinführung realisiert. Ein Anschluß der Drehkupplung (46) an die externen Fördereinrichtungen (47) kann in einfacher Weise über Anschlußrohre (48) durchgeführt werden, die teilweise unterhalb des Maschinensockels (15) verlaufen. Der Maschinensokkel (15) weist hierzu Standelemente (49) auf, die unterhalb des Maschinensockels (15) einen Montageraum dadurch bereitstellen, daß der Maschinensockel (15) mit vertikalem Abstand zu einer Aufstellfläche angeordnet ist.

Die Drehkupplung (46) ist über Leitungen (50) mit den jeweils zugeordneten Fördereinrichtungen (44) verbunden. Der Distanzschenkel (42) ist bei der Darstellung in Fig. 11 teilweise transparent abgebildet, so daß der Verlauf der Leitungen (50) zu erkennen ist.

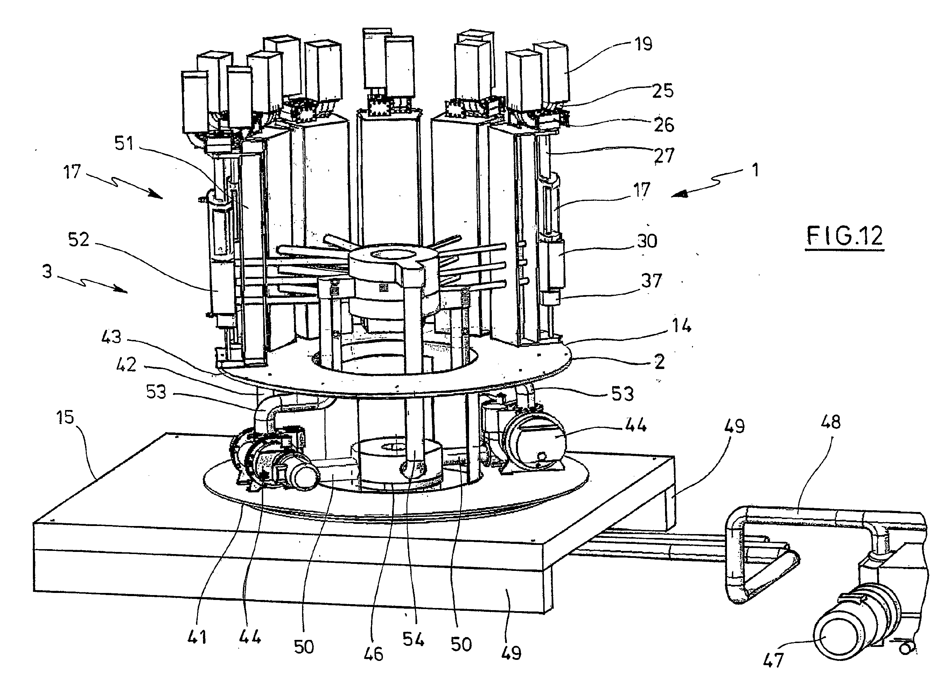

Fig. 12 zeigt die Anordnung gemäß Fig. 11 in einem teilmontierten Zustand. Insbesondere ist zu erkennen, daß auf einem Höhenniveau ähnlich zum Höhenniveau der Plasmakammern (17) ein Verteiler (51) angeordnet ist. Im dargestellten Ausführungsbeispiel ist der Verteiler (51) als ein Drei-Wege-Verteiler realisiert. Der Verteiler (51) weist hierzu drei in vertikaler Richtung übereinander angeordnete Verteilsegmente auf. Die Verteilsegmente sind jeweils über Anschlußleitungen (52) mit den Plasmakammern (17) verbunden. Beim dargestellten Ausführungsbeispiel werden zwei Betriebsmittel dem Verteiler (51) jeweils über eine Fördereinrichtung (44) zugeführt. Die Fördereinrichtungen (44) sind hierzu über Kopplungsleitungen (53) mit dem Verteiler (51) verbunden. Ein weiteres Betriebsmittel wird dem Verteiler (51) über eine Steigleitung (54) direkt von der Drehkupplung (46) zugeführt.

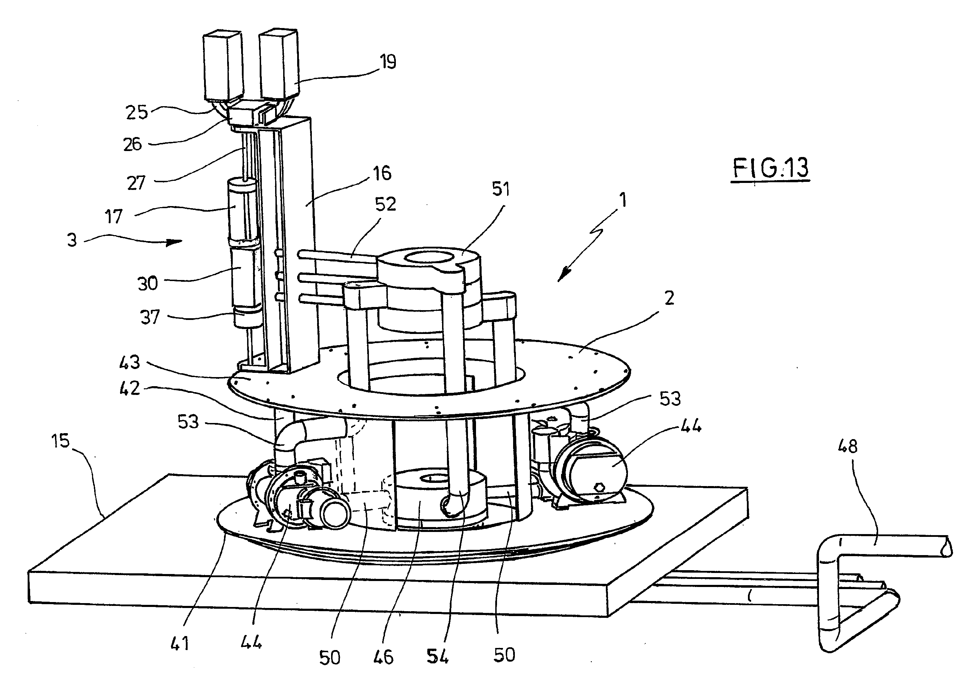

Fig. 13 zeigt zur weiteren Verdeutlichung die Anordnung gemäß Fig. 12 mit nur einer dargestellten Plasmastation (3). Insbesondere ist hier die Anordnung der drei Segmente des Verteilers (51) in lotrechter Richtung übereinander sowie der Verlauf der Anschlußleitungen (48) zwischen dem Verteiler (51) und dem Kammersockel (30) zu erkennen. Die Anschlußleitungen (52) sind hierbei direkt zu im Bereich des Kammersockels (30) angeordneten Ventilen geführt. Insbesondere veranschaulicht Fig. 13 auch, daß beim dargestellten Ausführungsbeispiel der Verteiler (51) von den Leitungen (52, 53) getragen ist. Hierdurch ist eine gute Zugänglichkeit gegeben. Es ist aber auch möglich, zusätzliche Tragelemente einzusetzen.

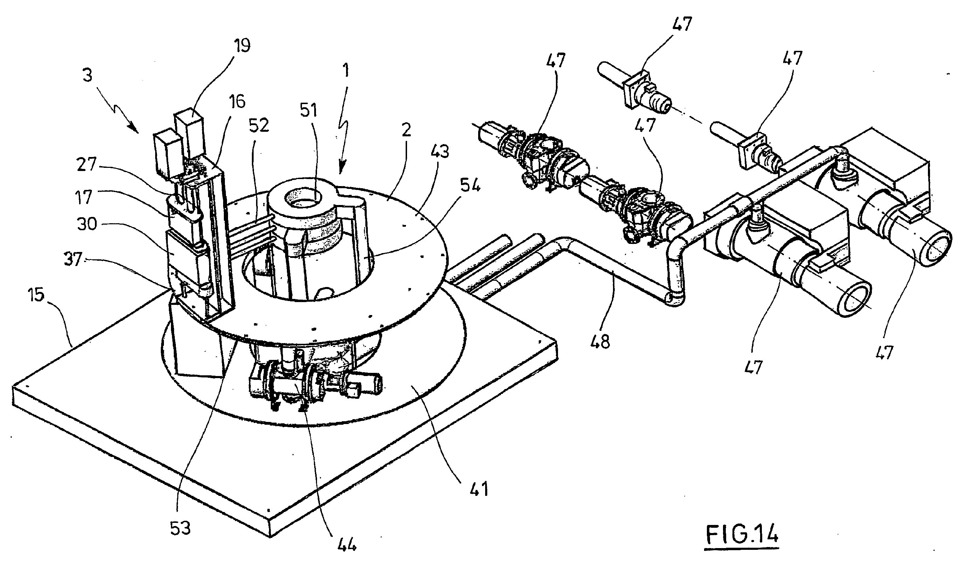

Fig. 14 zeigt die Anordnung gemäß Fig. 13 in einer anderen perspektivischen Darstellung sowie mit zugeordneten sechs externen Fördereinrichtungen (47). Jeder Unterdruckstufe sind hierbei zwei externe Fördereinrichtungen (47) zugeordnet. Beim dargestellten Ausführungsbeispiel stellen die Fördereinrichtungen (47) für die erste Unterdruckstufe einen Unterdruck im Bereich von etwa 30 mbar bis 50 mbar bereit. Dieser Unterdruck wird den Plasmastationen (3) beim dargestellten Ausführungsbeispiel ohne zusätzliche Fördereinrichtungen (44) auf dem Plasmarad (2) direkt über die Drehkupplung (46) zugeführt. Die Unterdrücke für die anderen externen Fördereinrichtungen (47) werden in Abhängigkeit von den jeweiligen Prozeßanforderungen vorgegeben. Insbesondere ist an einen Druckbereich von etwa 1 mbar bis 10 mbar gedacht. Als Fördereinrichtungen (44, 47) können Drehschieberpumpen, Wälzkolbenpumpen oder aus diesen Pumpentypen kombinierte Konstruktionen verwendet werden. Gemäß einer bevorzugten Ausführungsform werden als auf dem Plasmarad (2) angeordnete Fördereinrichtungen (44) Wälzkolbenpumpen und als externe Fördereinrichtungen (47) Drehschieberpumpen verwendet.

Zur Verminderung unnötig langer Anschlußrohre (48) ist insbesondere daran gedacht, die externen Fördereinrichtungen (47) benachbart zum Plasmamodul (1) zu positionieren. Hierzu kann beispielsweise ein spezielles Vorstufenmodul verwendet werden. Innerhalb eines derartigen Vorstufenmoduls können die benötigen externen Fördereinrichtungen (47) angeordnet werden und das Vorstufenmodul kann mit standardisierten Anschlüssen zur Verbindung mit dem Plasmamodul (1) ausgestattet werden. Hierdurch wird sowohl eine Montage als auch eine spätere Inbetriebnahme stark vereinfacht.

Bei der Ausführungsform gemäß Fig. 14 sind die zwei externen Fördereinrichtungen (47) für die erste Unterdruckstufe relativ zueinander parallel geschaltet. Die weiteren externen Fördereinrichtungen (47) für die relativ zur ersten Unterdruckstufe auf einem niedrigeren Druckniveau arbeitende zweite Unterdruckstufe sowie die dritte Unterdruckstufe zur Aufrechterhaltung des Unterdruckes während der Durchführung der Behandlung sind hingegen in Reihe geschaltet. Hierdurch wird berücksichtigt, daß es bei der Erzeugung des relativ höheren Unterdruckes primär darauf ankommt, ein relativ großes Volumen abzupumpen, bei den beiden relativ zur ersten Unterdruckstufe auf niedrigeren Druckniveaus arbeitenden weiteren Unterdruckstufen ist hingegen primär der angestrebte niedrige Druck zu erreichen, was durch die Reihenschaltung unterstützt wird.

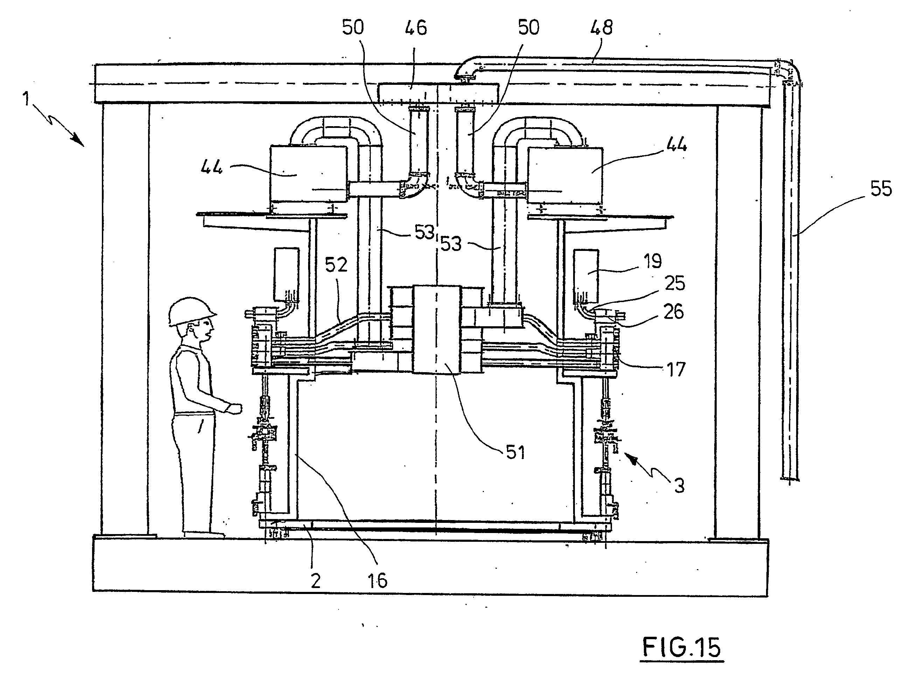

Fig. 15 zeigt eine Ausführungsform, bei der die Fördereinrichtungen (44) auf einem höheren Niveau als die Plasmastationen (3) angeordnet sind. Dies führt zwar zu einem höheren Schwerpunkt des Plasmarades (2), es wird dafür aber eine sehr gute Zugänglichkeit der Fördereinrichtungen (44) sowohl bei einer Montage als auch bei späteren Servicearbeiten bereitgestellt. Eine Kopplung mit den externen Fördereinrichtungen (47) erfolgt bei einer derartigen Ausführungsform vorzugsweise über Anschlußrohre (48), die zunächst oberhalb des Plasmamoduls (1) verlegt sind und über Vertikalleitungen (55) mit den externen Fördereinrichtungen (47) verbunden werden. Durch die Anordnung der Fördereinrichtungen (44) oberhalb der Plasmastationen (3) können die Plasmastationen (3) relativ niedrig angeordnet werden, so daß auch eine Eingabe und Ausgabe der zu beschichtenden Werkstücke (5) auf einem relativ geringen Höhenniveau erfolgen kann.

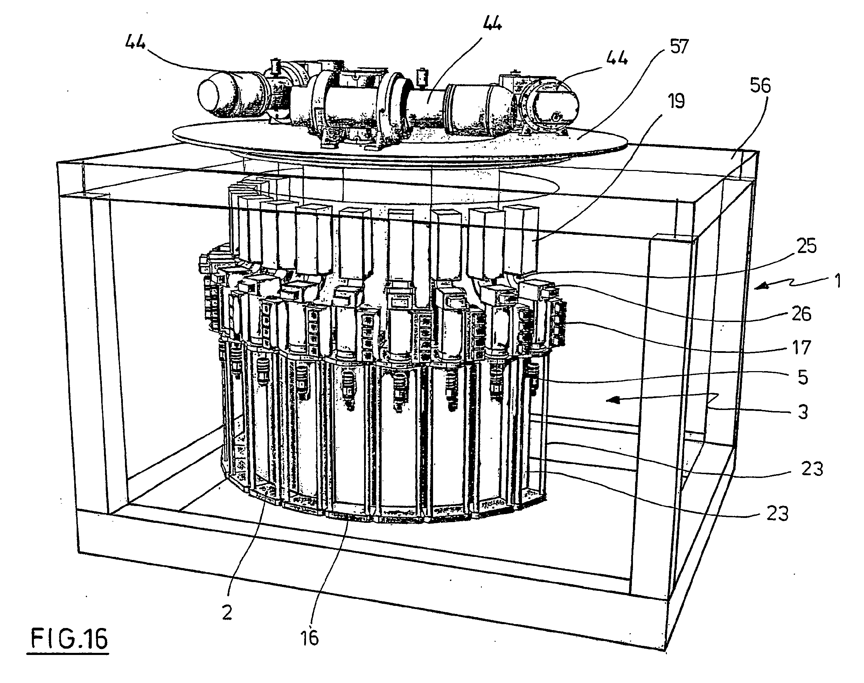

Fig. 16 zeigt eine weitere Ausführungsform des Plasmamoduls (1). Das Plasmarad (2) ist hier in einem Traggestell (56) aufgehängt. Im Gegensatz zu den bereits erläuterten Ausführungsformen befindet sich somit ein Drehlager (57) des Plasmarades (2) hierbei nicht in lotrechter Richtung unter dem Plasmarad (2), sondern in lotrechter Richtung oberhalb des Plasmarades (2). Der Aufbau der Plasmastation (3) kann grundsätzlich gegenüber den weiteren Ausführungsformen beibehalten werden. Fig. 16 zeigt die Plasmastation (3) lediglich in einer Teildarstellung ohne Kammersockel (30) und ohne den Lanzenschlitten (37) mit zugeordneten Bauelementen.

Bei einer Ausführungsform entsprechend Fig. 16 kann auch bei einer Verwendung von auf dem Plasmarad (2) angeordneten Fördereinrichtungen (44) eine relativ niedrige Anordnung der Plasmakammern (17) beibehalten werden. Beim dargestellten Ausführungsbeispiel werden auf dem Plasmarad (2) drei Fördereinrichtungen (44) positioniert. Relativ zu einem vom Traggestell (56) gehalterten Drehlager (57) sind die Plasmastationen (3) unterhalb des Drehlagers (57) und die Fördereinrichtungen (44) oberhalb des Drehlagers (57) angeordnet. Durch diese hohe Anordnung des Drehlagers (57) kann trotz der hohen Anordnung der Fördereinrichtungen (44) eine hohe konstruktive Stabilität bereitgestellt werden.

Ein typischer Behandlungsvorgang wird im folgenden am Beispiel eines Beschichtungsvorganges erläutert und derart durchgeführt, daß zunächst das Werkstück (5) unter Verwendung des Eingaberades (11) zum Plasmarad (2) transportiert wird und daß in einem hochgeschobenen Zustand der hülsenartigen Kammerwandung (18) das Einsetzen des Werkstückes (5) in die Plasmastation (3) erfolgt. Nach einem Abschluß des Einsetzvorganges wird die Kammerwandung (18) in ihre abgedichtete Positionierung abgesenkt und zunächst gleichzeitig eine Evakuierung sowohl der Kavität (4) als auch eines Innenraumes des Werkstückes (5) durchgeführt.

Nach einer ausreichenden Evakuierung des Innenraumes der Kavität (4) wird die Lanze (36) in den Innenraum des Werkstückes (5) eingefahren und durch eine Verschiebung des Dichtelementes (28) eine Abschottung des Innenraumes des Werkstückes (5) gegenüber dem Innenraum der Kavität (4) durchgeführt. Ebenfalls ist es möglich, die Lanze (36) bereits synchron zur beginnenden Evakuierung des Innenraumes der Kavität in das Werkstück (5) hinein zu verfahren. Der Druck im Innenraum des Werkstückes (5) wird anschließend noch weiter abgesenkt. Darüber hinaus ist auch daran gedacht, die Positionierbewegung der Lanze (36) wenigstens teilweise bereits parallel zur Positionierung der Kammerwandung (18) durchzuführen. Nach Erreichen eines ausreichend tiefen Unterdruckes wird Prozeßgas in den Innenraum des Werkstückes (5) eingeleitet und mit Hilfe des Mikrowellengenerators (19) das Plasma gezündet. Insbesondere ist daran gedacht, mit Hilfe des Plasmas sowohl einen Haftvermittler auf eine innere Oberfläche des Werkstückes (5) als auch die eigentliche Barriereschicht aus Siliziumoxiden abzuscheiden. Die Aufbringung des Haftvermittlers kann beispielsweise in einem zweistufigen Verfahren vor der Aufbringung der Barriereschicht erfolgen, es ist aber auch denkbar, in einem kontinuierlichen Verfahren wenigstens einen Teil der Barriereschicht auch bereits zeitgleich zum Aufbringen mindestens eines Teiles des Haftvermittlers zu erzeugen.

Der Innenraum der Plasmakammer (17) und der Innenraum des Werkstückes (5) werden zunächst gemeinsam auf ein Druckniveau von etwa 20 mbar bis 50 mbar evakuiert. Anschließend wird der Druck im Innenraum des Werkstückes (5) weiter auf etwa 0,1 mbar abgesenkt. Während der Durchführung des Behandlungsvorganges wird ein Unterdruck von etwa 0,3 mbar aufrechterhalten.

Nach einem Abschluß des Beschichtungsvorganges wird die Lanze (36) wieder aus dem Innenraum des Werkstückes (5) entfernt und die Plasmakammer (17) sowie der Innenraum des Werkstückes (5) werden belüftet. Nach Erreichen des Umgebungsdruckes innerhalb der Kavität (4) wird die Kammerwandung (18) wieder angehoben, um eine Entnahme des beschichteten Werkstückes (5) sowie eine Eingabe eines neuen zu beschichtenden Werkstückes (5) durchzuführen. Zur Ermöglichung einer seitlichen Positionierung des Werkstückes (5) wird das Dichtelement (28) mindestens bereichsweise wieder in den Kammersockel (3) hinein verfahren.

Alternativ zur erläuterten Innenbeschichtung von Werkstükken (5) können auch Außenbeschichtungen, Sterilisationen oder Oberflächenaktivierungen durchgeführt werden.

Eine Positionierung der Kammerwandung (18), des Dichtelementes (28) und / oder der Lanze (36) kann unter Verwendung unterschiedlicher Antriebsaggregate erfolgen. Grundsätzlich ist die Verwendung pneumatischer Antriebe und / oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades (2) eine Kurvensteuerung zu realisieren. Die Kurvensteuerung kann beispielsweise derart ausgeführt sein, daß entlang eines Umfanges des Plasmarades (2) Steuerkurven angeordnet sind, entlang derer Kurvenrollen geführt werden. Die Kurvenrollen sind mit den jeweils zu positionierenden Bauelementen gekoppelt.

## Patentansprüche

1. verfahren zur Plasmabehandlung von Werkstücken (5), bei dem ein als Behälter ausgebildetes Werkstück (5) mit einer Innenbeschichtung als Barriereschicht versehen wird, wobei zur Erzeugung der Barriereschicht ein Prozeßgas verwendet wird und bei dem das Werkstück in eine zumindest teilweise evakuierbare Kammer (17) einer Behandlungsstation eingesetzt wird und bei dem das Werkstück (5) innerhalb der Behandlungsstation von einem Halteelement (46) positioniert wird und bei dem mindestens ein Betriebsmittel mindestens teilweise von einer Fördereinrichtung (44) beaufschlagt wird, **dadurch gekennzeichnet, daß** die Fördereinrichtung (44) gemeinsam mit der Behandlungsstation auf einem geschlossenen und umlaufenden Transportweg bewegt wird, wobei von der Fördereinrichtung (44) ein Unterdruck erzeugt wird und wobei die Fördereinrichtung (44) auf einem niedrigeren Höhenniveau als die Kammern (17) positioniert wird.

2. verfahren nach Anspruch 1, **dadurch gekennzeichnet, daß** von mindestens zwei Fördereinrichtungen (44) mindestens zwei unterschiedliche Unterdrücke erzeugt werden

3. Verfahren nach einem der Ansprüche 1, oder 2, **dadurch gekennzeichnet, daß** für mindestens eine Fördereinrichtung (44) von mindestens einer externen Vorstufe ein vorkonditioniertes Betriebsmittel bereitgestellt wird.

4. verfahren nach einem der Ansprüche 1 bis 3, **dadurch gekennzeichnet, daß** das Betriebsmittel über eine Drehkupplung (46) in den Bereich der Fördereinrichtung (44) geleitet wird.

5. Verfahren nach einem der Ansprüche 1 bis 4, **dadurch gekennzeichnet, daß** die Fördereinrichtung (44) das Betriebsmittel von einem Höhenniveau der Fördereinrichtung (44) auf ein höheres Montageniveau der Plasmastation (3) transportiert.

6. Verfahren nach einem der Ansprüche 1 bis 5, **dadurch gekennzeichnet, daß** mindestens zwei Plasmastationen (3) über einen Verteiler (51) mit mindestens einer gemeinsamen Fördereinrichtung (44) verbunden werden.

7. Verfahren nach einem der Ansprüche 1 bis 6, **dadurch gekennzeichnet, daß** mindestens ein Betriebsmittel von mindestens einem Verteiler (53) auf einem Höhenniveau eines Kammersockels (30) der Plasmastation (3) verteilt wird.

8. Verfahren nach einem der Ansprüche 1 bis 7, **dadurch gekennzeichnet, daß** eine Zuführung des Betriebsmittels vom Verteiler (51) in Richtung auf die Plasmastationen (3) über gerade und ausgehend vom Verteiler (51) radial nach außen verlaufende Anschlußleitungen (52) durchgeführt wird.

9. Verfahren nach einem der Ansprüche 1 bis 8, **dadurch gekennzeichnet, daß** mindestens zwei Betriebsmittel auf unterschiedlichen Verteilebenen zu den Plasmastationen (3) geleitet werden.

10. Verfahren nach einem der Ansprüche 1 bis 9, **dadurch gekennzeichnet, daß** die Fördereinrichtungen (44) im Bereich der Trageinrichtung derart angeordnet werden, daß eine im wesentlichen ausgewuchtete Gewichtsverteilung bereitgestellt wird.

11. verfahren nach einem der Ansprüche 1 bis 10, **dadurch gekennzeichnet, daß** entlang eines Umfanges der Trageinrichtung abwechselnd Fördereinrichtungen (44) sowie Verteilschränke (45) für elektrische Anschlüsse positioniert werden.

12. Verfahren nach einem der Ansprüche 1 bis 11, **dadurch gekennzeichnet, daß** die Fördereinrichtung (44) gemeinsam mit der Plasmastation (3) auf einem rotierenden Plasmarad (2) als Trageinrichtung positioniert wird.

13. Verfahren nach einem der Ansprüche 1 bis 12, **dadurch gekennzeichnet, daß** ein Werkstück (5) aus einem thermoplastischen Kunststoff behandelt wird.

14. verfahren nach einem der Ansprüche 1 bis 13, **dadurch gekennzeichnet, daß** als Werkstück (5) eine Getränkeflasche behandelt wird.

15. verfahren nach einem der Ansprüche 1 bis 14, **dadurch gekennzeichnet, daß** die mindestens eine Plasmastation (3) von einem rotierenden Plasmarad (2) von einer Eingabepositionierung in eine Ausgabepositionierung überführt wird.

16. Verfahren nach einem der Ansprüche 1 bis 15, **dadurch gekennzeichnet, daß** von einer Plasmastation (3) mehrere Kavitäten (4) bereitgestellt werden.

17. Verfahren nach einem der Ansprüche 1 bis 16, **dadurch gekennzeichnet, daß** die Fördereinrichtungen (44) von einem radringartigen Plasmarad (2) transportiert werden.

18. verfahren nach einem der Ansprüche 1 bis 17, **dadurch gekennzeichnet, daß** die Plasmabehandlung unter Verwendung eines Niederdruckplasmas durchgeführt wird.

19. Verfahren nach einem der Ansprüche 1 bis 18, **dadurch gekennzeichnet, daß** eine Plasmapolymerisation durchgeführt wird.

20. verfahren nach einem der Ansprüche 1 bis 19, **dadurch gekennzeichnet, daß** durch das Plasma mindestens zum Teil organische Substanzen abgeschieden werden.

21. Verfahren nach einem der Ansprüche 1 bis 20, **dadurch gekennzeichnet, daß** durch das Plasma mindestens zum Teil anorganische Substanzen abgeschieden werden.

22. Verfahren nach einem der Ansprüche 21, **dadurch gekennzeichnet, daß** zusätzlich ein Haftvermittler zur Verbesserung eines Anhaftens der Substanz auf einer Oberfläche des Werkstückes (5) abgeschieden wird.

23. Verfahren nach einem der Ansprüche 1 bis 22, **dadurch gekennzeichnet, daß** in einer gemeinsamen Kavität mindestens zwei Werkstücke (5) gleichzeitig behandelt werden.

24. Verfahren nach einem der Ansprüche 1 bis 23, **dadurch gekennzeichnet, daß** als Plasmabehandlung eine Plasmasterilisation durchgeführt wird.

25. Verfahren nach einem der Ansprüche 1 bis 24, **dadurch gekennzeichnet, daß** als Plasmabehandlung eine Oberflächenaktivierung des Werkstückes (5) durchgeführt wird.

26. Vorrichtung zur Plasmabehandlung von Werkstücken (5), bei dem ein als Behälter ausgebildetes Werkstück (5) mit einer Innenbeschichtung als Barriereschicht versehen wird, wobei zur Erzeugung der Barriereschicht ein Prozeßgas verwendet wird und die mindestens eine evakuierbare Plasmakammer (17) zur Aufnahme der Werkstücke (5) aufweist und bei der die Plasmakammer (17) im Bereich einer Behandlungsstation angeordnet ist, sowie bei der die Plasmakammer (17) von einem Kammerboden (29), einem Kammerdeckel (31) sowie einer seitlichen Kammerwandung (18) begrenzt ist und mindestens ein Halteelement (46) zur Positionierung des Werkstückes (5) aufweist und bei der die Plasmakammer (17) auf einer umlaufenden Trageinrichtung angeordnet ist, dadurch gedurch gekennzeichnet, daß mindestens eine Fördereinrichtung (44) für ein Betriebsmittel auf der umlaufenden Trageinrichtung angeordnet ist, daß die Fördereinrichtung (44) zur Erzeugung eines Unterdruckes ausgebildet ist und daß die Fördereinrichtung (44) auf einem niedrigeren Höhenniveau als die Plasmakammern (17) angeordnet ist.

27. Vorrichtung nach Anspruch 26, **dadurch gekennzeichnet, daß** auf der Trageinrichtung mindestens zwei Fördereinrichtungen (44) zur Erzeugung relativ zueinander unterschiedlicher Unterdrücke angeordnet sind.

28. Vorrichtung nach einem der Ansprüche 26 oder 27, **dadurch gekennzeichnet, daß** mindestens eine der Fördereinrichtungen (44) an mindestens eine externe Fördereinrichtung (47) zur Bereitstellung eines vorkonditionierten Betriebsmittels angeschlossen ist.

29. Vorrichtung nach einem der Ansprüche 26 bis 28, **dadurch gekennzeichnet, daß** die Fördereinrichtung (44) über eine Drehkupplung (46) an eine externe Betriebsmittelversorgung angeschlossen ist.

30. Vorrichtung nach einem der Ansprüche 26 bis 29, **dadurch gekennzeichnet, daß** die Fördereinrichtung (44) über einen Verteiler (51) an mindestens zwei Plasmastationen (3) angeschlossen ist.

31. Vorrichtung nach einem der Ansprüche 26 bis 30, **dadurch gekennzeichnet, daß** der Verteiler (51) auf einem Höhenniveau wie ein Kammersockel (30) der Plasmastation (3) angeordnet ist.

32. Vorrichtung nach einem der Ansprüche 26 bis 31, **dadurch gekennzeichnet, daß** der Verteiler (51) über im wesentlichen radial nach außen verlaufende Anschlußleitungen (52) mit dem Kammersockel (30) verbunden ist.

33. Vorrichtung nach einem der Ansprüche 26 bis 32, **dadurch gekennzeichnet, daß** der Verteiler (51) zur Verteilung unterschiedlicher Betriebsmittel unterschiedliche Verteilebenen aufweist.

34. Vorrichtung nach einem der Ansprüche 26 bis 33, **dadurch gekennzeichnet, daß** mindestens zwei Fördereinrichtungen (44) im wesentlichen ausgewuchtet auf der Trageinrichtung angeordnet sind.

35. Vorrichtung nach einem der Ansprüche 26 bis 34, **dadurch gekennzeichnet, daß** entlang eines Umfanges der Trageinrichtung abwechselnd Fördereinrichtungen (44) sowie Verteilschränke (45) für elektrische Anschlüsse angeordnet sind.

36. Vorrichtung nach einem der Ansprüche 26 bis 35, **dadurch gekennzeichnet, daß** die Fördereinrichtung (44) auf einer als Plasmarad (2) ausgebildeten Trageinrichtung angeordnet ist.

37. Vorrichtung nach einem der Ansprüche 26 bis 36, **dadurch gekennzeichnet, daß** die Plasmastation (3) zur Beschichtung eines aus einem thermoplastischen Kunststoff bestehenden Werkstückes (5) ausgebildet ist.

38. Vorrichtung nach einem der Ansprüche 26 bis 37, **dadurch gekennzeichnet, daß** die Plasmastation (3) zur Beschichtung eines in Form einer Getränkeflasche gestalteten Werkstückes (5) ausgebildet ist.

39. Vorrichtung nach einem der Ansprüche 26 bis 38, **dadurch gekennzeichnet, daß** die mindestens eine Plasmastation (3) von einem rotierenden Plasmarad (2) getragen ist.

40. Vorrichtung nach einem der Ansprüche 26 bis 39, **dadurch gekennzeichnet, daß** im Bereich der Plasmastation (3) mehrere Kavitäten (4) angeordnet sind.

41. Vorrichtung nach einem der Ansprüche 26 bis 40, **dadurch gekennzeichnet, daß** eine zur Bereitstellung von mindestens zwei Kavitäten (4) vorgesehene Kammerwandung (18) positionierbar angeordnet ist.

42. Vorrichtung nach einem der Ansprüche 26 bis 41, **dadurch gekennzeichnet, daß** das Plasmarad (2) als ein Radring ausgebildet ist.

43. Vorrichtung nach einem der Ansprüche 26 bis 42, **dadurch gekennzeichnet, daß** das Plasmarad (2) mit einem Tragring (14) versehen ist, der ein im wesentlichen c-förmiges vertikalprofil aufweist.

44. Vorrichtung nach Anspruch 43, **dadurch gekennzeichnet, daß** die Fördereinrichtung (44) auf einem Basisschenkel (41) des Tragringes (14) angeordnet ist.

45. Vorrichtung nach Anspruch 43 oder 44, **dadurch gekennzeichnet, daß** die Plasmastationen (3) auf einem Abschlußschenkel (43) des Tragringes (14) angeordnet sind.

46. Vorrichtung nach einem der Ansprüche 26 bis 45, **dadurch gekennzeichnet, daß** mindestens zwei externe Fördereinrichtungen (47) relativ zueinander parallel geschaltet sind.

47. Vorrichtung nach einem der Ansprüche 26 bis 45, **dadurch gekennzeichnet, daß** mindestens zwei externe Fördereinrichtungen (47) relativ zueinander in Reihe geschaltet sind.

## Claims

1. Method for the plasma treatment of workpieces (5), in which a workpiece (5) designed as a container is provided with an internal coating as barrier layer, wherein a process gas is used for generating the barrier layer, and in which the workpiece is inserted into an at least partly evacuable chamber (17) of a treatment station and in which the workpiece (5) is positioned within the treatment station by a holding element (46), and in which at least one operating medium is at least partially acted on by a delivery device (44), **characterized in that** the delivery device (44) is moved together with the treatment station on a continuous, and encircling transport path, wherein the delivery device (44) generates a subatmospheric pressure and wherein the delivery device (44) is positioned at a lower height level than the chambers (17).

2. Method according to Claim 1, **characterized in that** at least two different subatmospheric pressures are generated by at least two delivery devices (44).

3. Method according to one of Claims 1 and 2, **characterized in that** a preconditioned operating medium is provided by at least one external preliminary stage for at least one delivery device (44).

4. Method according to one of Claims 1 to 3, **characterized in that** the operating medium is passed into the region of the delivery device (44) via a rotary coupling (46).

5. Method according to one of Claims 1 to 4, **characterized in that** the delivery device (44) transports the operating medium from a height level of the delivery device (44) to a higher level of the plasma station (3).

6. Method according to one of Claims 1 to 5, **characterized in that** at least two plasma stations (3) are connected to at least one common delivery device (44) via a distributor (51).

7. Method according to one of Claims 1 to 6, **characterized in that** at least one operating medium is distributed at a height level of a chamber pedestal (30) of the plasma station (3) by at least one distributor (53).

8. Method according to one of Claims 1 to 7, **characterized in that** a feed of the operating medium from the distributor (51) towards the plasma stations (3) is realized via straight connecting lines (52) which lead radially outwards from the distributor (51).

9. Method according to one of Claims 1 to 8, **characterized in that** at least two operating media are passed to the plasma stations (3) on different distribution planes.

10. Method according to one of Claims 1 to 9, **characterized in that** the delivery devices (44) are arranged in such a manner in the region of the carrier device that a substantially balanced weight distribution is provided.

11. Method according to one of Claims 1 to 10, **characterized in that** delivery devices (44) and distribution boxes (45) for electrical connections are positioned alternately along a circumference of the carrier device.

12. Method according to one of Claims 1 to 11, **characterized in that** the delivery device (44) together with the plasma station (3) is positioned on a rotating plasma wheel (2) as carrier device.

13. Method according to one of Claims 1 to 12, **characterized in that** a workpiece (5) made from a thermoplastic is treated.

14. Method according to one of Claims 1 to 13, **characterized in that** the workpiece (5) treated is a drinks bottle.

15. Method according to one of Claims 1 to 14, **characterized in that** the at least one plasma station (3) is transferred from an introduction position into a discharge position by a rotating plasma wheel (2).

16. Method according to one of Claims 1 to 15, **characterized in that** a plurality of cavities (4) are provided by one plasma station (3).

17. Method according to one of Claims 1 to 16, **characterized in that** the delivery devices (44) are transported by a plasma wheel (2) which is in the form of a wheel ring.

18. Method according to one of Claims 1 to 17, **characterized in that** the plasma treatment is carried out using a low-pressure plasma.

19. Method according to one of Claims 1 to 18, **characterized in that** a plasma polymerization is carried out.

20. Method according to one of Claims 1 to 19, **characterized in that** the plasma deposits at least partially organic substances.

21. Method according to one of Claims 1 to 20, **characterized in that** the plasma deposits at least partially inorganic substances.

22. Method according to one of Claims 1 to 21, **characterized in that** a bonding agent for improving bonding of the substance to a surface of the workpiece (5) is additionally deposited.

23. Method according to one of Claims 1 to 22, **characterized in that** at least two workpieces (5) are treated simultaneously in a common cavity.

24. Method according to one of Claims 1 to 23, **characterized in that** the plasma treatment carried out is a plasma sterilization.

25. Method according to one of Claims 1 to 24, **characterized in that** the plasma treatment carried out is a surface activation of the workpiece (5).

26. Apparatus for the plasma treatment of workpieces (5), in which a workpiece (5) designed as a container is provided with an internal coating as barrier layer, wherein a process gas is used for generating the barrier layer, and which has at least one evacuable plasma chamber (17) for receiving the workpieces (5) and in which the plasma chamber (17) is arranged in the region of a treatment station, and in which the plasma chamber (17) is delimited by a chamber base (29), a chamber cover (31) and a lateral chamber wall (18), and has at least one holding element (46) for positioning the workpiece (5), and in which the plasma chamber (17) is arranged on a rotating carrier device, **characterized in that** at least one delivery device (44) for an operating medium is arranged on the rotating carrier device, **in that** the delivery device (44) is designed to generate a subatmospheric pressure and **in that** the delivery device (44) is arranged at a lower height level than the plasma chambers (17).

27. Apparatus according to Claim 26, **characterized in that** at least two delivery devices (44) for generating subatmospheric pressures which are different from one another are arranged on the carrier device.

28. Apparatus according to one of Claims 26 and 27, **characterized in that** at least one of the delivery devices (44) is connected to at least one external delivery device (47) for providing a preconditioned operating medium.

29. Apparatus according to one of Claims 26 to 28, **characterized in that** the delivery device (44) is connected to an external operating-medium supply via a rotary coupling (46).

30. Apparatus according to one of Claims 26 to 29, **characterized in that** the delivery device (44) is connected to at least two plasma stations (3) via a distributor (51).

31. Apparatus according to one of Claims 26 to 30, **characterized in that** the distributor (51) is arranged at the same height level as a chamber pedestal (30) of the plasma station (3).

32. Apparatus according to one of Claims 26 to 31, **characterized in that** the distributor (51) is connected to the chamber pedestal (30) via connecting lines (52) which run substantially radially outwards.

33. Apparatus according to one of Claims 26 to 32, **characterized in that** the distributor (51) has different distribution planes for distributing different operating media.

34. Apparatus according to one of Claims 26 to 33, **characterized in that** at least two delivery devices (44) are in a substantially balanced arrangement on the carrier device.

35. Apparatus according to one of Claims 26 to 34, **characterized in that** delivery devices (44) and distribution boxes (45) for electrical connections are arranged alternately along a circumference of the carrier device.

36. Apparatus according to one of Claims 26 to 35, **characterized in that** the delivery device (44) is arranged on a carrier device designed as a plasma wheel (2).

37. Apparatus according to one of Claims 26 to 36, **characterized in that** the plasma station (3) is designed to coat a workpiece (5) consisting of a thermoplastic.

38. Apparatus according to one of Claims 26 to 37, **characterized in that** the plasma station (3) is designed to coat a workpiece (5) configured in the form of a drinks bottle.

39. Apparatus according to one of Claims 26 to 38, **characterized in that** the at least one plasma station (3) is carried by a rotating plasma wheel (2).

40. Apparatus according to one of Claims 26 to 39, **characterized in that** a plurality of cavities (4) are arranged in the region of the plasma station (3).

41. Apparatus according to one of Claims 26 to 40, **characterized in that** a chamber wall (18) which is intended to provide at least two cavities (4) is arranged positionably.

42. Apparatus according to one of Claims 26 to 41, **characterized in that** the plasma wheel (2) is designed as a wheel ring.

43. Apparatus according to one of Claims 26 to 42, **characterized in that** the plasma wheel (2) is provided with a carrier ring (14) which has a substantially C-shaped vertical profile.

44. Apparatus according to Claim 43, **characterized in that** the delivery device (44) is arranged on a base limb (41) of the carrier ring (14).

45. Apparatus according to Claim 43 or 44, **characterized in that** the plasma stations (3) are arranged on a terminating limb (43) of the carrier ring (14).

46. Apparatus according to one of Claims 26 to 45, **characterized in that** at least two external delivery devices (47) are connected in parallel with one another.

47. Apparatus according to one of Claims 26 to 45, **characterized in that** at least two external delivery devices (47) are connected in series with one another.

## Revendications

1. Procédé pour le traitement par plasma de pièces (5), dans lequel une pièce (5) réalisée sous forme de récipient est munie d'un revêtement interne en tant que couche barrière, un gaz de processus étant utilisé pour produire la couche barrière, et dans lequel la pièce est introduite dans une chambre (17) d'un poste de traitement au moins partiellement évacuée, et dans lequel la pièce (5) est positionnée à l'intérieur du poste de traitement par un élément de retenue (46) et dans lequel au moins un milieu de travail est sollicité au moins en partie par un dispositif de transport (44), **caractérisé en ce que** le dispositif de transport (44) est déplacé conjointement avec le poste de traitement sur une voie de transport fermée et circonférentielle, une dépression étant produite par le dispositif de transport (44) et le dispositif de transport (44) étant positionné à un niveau en hauteur plus bas que les chambres (17).

2. Procédé selon la revendication 1, **caractérisé en ce qu'**au moins deux dépressions différentes sont produites par au moins deux dispositifs de transport (44).

3. Procédé selon l'une quelconque des revendications 1 ou 2, **caractérisé en ce que** pour au moins un dispositif de transport (44), un milieu de travail préconditionné est fourni par au moins un précurseur externe.

4. Procédé selon l'une quelconque des revendications 1 à 3, **caractérisé en ce que** le milieu de travail est introduit par le biais d'un accouplement rotatif (46) dans la région du dispositif de transport (44).

5. Procédé selon l'une quelconque des revendications 1 à 4, **caractérisé en ce que** le dispositif de transport (44) transporte le milieu de travail depuis un niveau en hauteur du dispositif de transport (44) à un niveau de montage plus élevé du poste à plasma (3).

6. Procédé selon l'une quelconque des revendications 1 à 5, **caractérisé en ce qu'**au moins deux postes à plasma (3) sont connectés par le biais d'un distributeur (51) à au moins un dispositif de transport commun (44).

7. Procédé selon l'une quelconque des revendications 1 à 6, **caractérisé en ce qu'**au moins un milieu de travail est distribué par au moins un distributeur (53) à un niveau en hauteur d'un socle de chambre (30) du poste à plasma (3).

8. Procédé selon l'une quelconque des revendications 1 à 7, **caractérisé en ce qu'**une alimentation en milieu de travail depuis le distributeur (51) dans la direction des postes à plasma (3) est effectuée par le biais de conduites de raccordement (52) s'étendant en ligne droite et radialement vers l'extérieur à partir du distributeur (51).

9. Procédé selon l'une quelconque des revendications 1 à 8, **caractérisé en ce qu'**au moins deux milieux de travail sont guidés sur des plans de distribution différents vers les postes à plasma (3).

10. Procédé selon l'une quelconque des revendications 1 à 9, **caractérisé en ce que** les dispositifs de transport (44) sont disposés dans la région du dispositif de support de telle sorte que l'on obtienne une répartition pondérale essentiellement équilibrée.

11. Procédé selon l'une quelconque des revendications 1 à 10, **caractérisé en ce que** des dispositifs de transport (44) ainsi que des armoires de distribution (45) pour des connexions électriques sont positionnés en alternance le long d'une périphérie du dispositif de support.

12. Procédé selon l'une quelconque des revendications 1 à 11, **caractérisé en ce que** le dispositif de transport (44) est positionné conjointement avec le poste à plasma (3) sur une roue à plasma rotative (2) servant de dispositif de support.

13. Procédé selon l'une quelconque des revendications 1 à 12, **caractérisé en ce qu'**une pièce (5) en matériau thermoplastique est traitée.

14. Procédé selon l'une quelconque des revendications 1 à 13, **caractérisé en ce que** la pièce (5) traitée est une bouteille à boisson.

15. Procédé selon l'une quelconque des revendications 1 à 14, **caractérisé en ce que** l'au moins un poste à plasma (3) est transféré par une roue à plasma rotative (2) depuis une position d'entrée à une position de décharge.

16. Procédé selon l'une quelconque des revendications 1 à 15, **caractérisé en ce que** plusieurs cavités (4) sont fournies par un poste à plasma (3).

17. Procédé selon l'une quelconque des revendications 1 à 16, **caractérisé en ce que** les dispositifs de transport (44) sont transportés par une roue à plasma (2) en forme d'enjoliveur.

18. Procédé selon l'une quelconque des revendications 1 à 17, **caractérisé en ce que** le traitement par plasma est effectué en utilisant un plasma à basse pression.

19. Procédé selon l'une quelconque des revendications 1 à 18, **caractérisé en ce que** l'on effectue une polymérisation par plasma.

20. Procédé selon l'une quelconque des revendications 1 à 19, **caractérisé en ce que** des substances au moins en partie organiques sont déposées par le plasma.

21. Procédé selon l'une quelconque des revendications 1 à 20, **caractérisé en ce que** des substances au moins en partie inorganiques sont déposées par le plasma.

22. Procédé selon l'une quelconque des revendications 1 à 21, **caractérisé en ce qu'**un promoteur d'adhésion pour améliorer l'adhésion de la substance à une surface de la pièce (5) est en outre déposé.

23. Procédé selon l'une quelconque des revendications 1 à 22, **caractérisé en ce qu'**au moins deux pièces (5) sont traitées simultanément dans une cavité commune.

24. Procédé selon l'une quelconque des revendications 1 à 23, **caractérisé en ce que** le traitement par plasma est une stérilisation par plasma.

25. Procédé selon l'une quelconque des revendications 1 à 24, **caractérisé en ce que** le traitement par plasma est une activation de surface de la pièce (5).

26. Dispositif pour le traitement par plasma de pièces (5), dans lequel une pièce (5) réalisée sous forme de récipient est munie d'un revêtement interne en tant que couche barrière, un gaz de processus étant utilisé pour produire la couche barrière, et qui présente au moins une chambre à plasma (17) pouvant être évacuée destinée à recevoir les pièces (5), et dans lequel la chambre à plasma (17) est disposée dans la région d'un poste de traitement, et dans lequel la chambre à plasma (17) est limitée par un fond de chambre (29), un couvercle de chambre (31) ainsi qu'une paroi latérale de chambre (18) et présente au moins un élément de retenue (46) pour le positionnement de la pièce (5) et dans lequel la chambre à plasma (17) est disposée sur un dispositif de support entraîné en rotation, **caractérisé en ce qu'**au moins un dispositif de transport (44) pour un milieu de travail est disposé sur le dispositif de support entraîné en rotation, **en ce que** le dispositif de transport (44) est réalisé de manière à produire une dépression, et **en ce que** le dispositif de transport (44) est disposé à un niveau en hauteur plus bas que les chambres à plasma (17).

27. Dispositif selon la revendication 26, **caractérisé en ce qu'**au moins deux dispositifs de transport (44) sont disposés sur le dispositif de support pour produire des dépressions différentes les unes par rapport aux autres.

28. Dispositif selon l'une quelconque des revendications 26 ou 27, **caractérisé en ce qu'**au moins l'un des dispositifs de transport (44) est raccordé à au moins un dispositif de transport externe (47) pour fournir un milieu de travail préconditionné.

29. Dispositif selon l'une quelconque des revendications 26 à 28, **caractérisé en ce que** le dispositif de transport (44) est raccordé à une alimentation externe en milieu de travail par le biais d'un accouplement rotatif (46).

30. Dispositif selon l'une quelconque des revendications 26 à 29, **caractérisé en ce que** le dispositif de transport (44) est raccordé à au moins deux postes de plasma (3) par le biais d'un distributeur (51).

31. Dispositif selon l'une quelconque des revendications 26 à 30, **caractérisé en ce que** le distributeur (51) est disposé à un même niveau en hauteur qu'un socle de chambre (30) du poste à plasma (3).

32. Dispositif selon l'une quelconque des revendications 26 à 31, **caractérisé en ce que** le distributeur (51) est connecté au socle de chambre (30) par le biais de conduites de raccordement (52) s'étendant essentiellement radialement vers l'extérieur.

33. Dispositif selon l'une quelconque des revendications 26 à 32, **caractérisé en ce que** le distributeur (51) présente des plans de distribution différents pour distribuer des milieux de travail différents.

34. Dispositif selon l'une quelconque des revendications 26 à 33, **caractérisé en ce qu'**au moins deux dispositifs de transport (44) sont disposés sur le dispositif de support de manière essentiellement équilibrée.

35. Dispositif selon l'une quelconque des revendications 26 à 34, **caractérisé en ce que** des dispositifs de transport (44) ainsi que des armoires de distribution (45) pour des connexions électriques sont disposés en alternance le long d'une périphérie du dispositif de support.

36. Dispositif selon l'une quelconque des revendications 26 à 35, **caractérisé en ce que** le dispositif de transport (44) est disposé sur un dispositif de support réalisé sous forme de roue à plasma (2).

37. Dispositif selon l'une quelconque des revendications 26 à 36, **caractérisé en ce que** le poste à plasma (3) est réalisé en vue du revêtement d'une pièce (5) constituée d'un matériau thermoplastique.

38. Dispositif selon l'une quelconque des revendications 26 à 37, **caractérisé en ce que** le poste à plasma (3) est réalisé en vue du revêtement d'une pièce (5) configurée en forme de bouteille à boisson.

39. Dispositif selon l'une quelconque des revendications 26 à 38, **caractérisé en ce que** l'au moins un poste à plasma (3) est porté par une roue à plasma rotative (2).

40. Dispositif selon l'une quelconque des revendications 26 à 39, **caractérisé en ce que** plusieurs cavités (4) sont disposées dans la région du poste à plasma (3).

41. Dispositif selon l'une quelconque des revendications 26 à 40, **caractérisé en ce qu'**une paroi de chambre (18) prévue pour fournir au moins deux cavités (4) est disposée de manière à pouvoir être positionnée.

42. Dispositif selon l'une quelconque des revendications 26 à 41, **caractérisé en ce que** la roue à plasma (2) est réalisée en forme d'enjoliveur.

43. Dispositif selon l'une quelconque des revendications 26 à 42, **caractérisé en ce que** la roue à plasma (2) est pourvue d'une bague de support (14) qui présente un profil vertical essentiellement en forme de C.

44. Dispositif selon la revendication 43, **caractérisé en ce que** le dispositif de transport (44) est disposé sur une branche de base (41) de la bague de support (14).

45. Dispositif selon la revendication 43 ou 44, **caractérisé en ce que** les postes à plasma (3) sont disposés sur une branche de terminaison (43) de la bague de support (14).

46. Dispositif selon l'une quelconque des revendications 26 à 45, **caractérisé en ce qu'**au moins deux dispositifs de transport externes (47) sont montés en parallèle les uns par rapport aux autres.

47. Dispositif selon l'une quelconque des revendications 26 à 45, **caractérisé en ce qu'**au moins deux dispositifs de transport externes (47) sont montés en série les uns par rapport aux autres.
